Europäisches Patentamt

European Patent Office

Office européen des brevets

(11) Veröffentlichungsnummer: **0 415 059 A2**

## (12) EUROPÄISCHE PATENTANMELDUNG

(21) Anmeldenummer: 90113879.2

(22) Anmeldetag: 19.07.90

(51) Int. Cl.⁵: **H01L 23/051**, H01L 23/16, H01L 23/62

Die Bezeichnung der Erfindung wurde geändert (Richtlinien für die Prüfung im EPA, A-III, 7.3).

(30) Priorität: 31.07.89 DE 3925328
12.12.89 DE 3941041

(43) Veröffentlichungstag der Anmeldung:
06.03.91 Patentblatt 91/10

(84) Benannte Vertragsstaaten:
CH DE FR LI

(71) Anmelder: **Siemens Aktiengesellschaft
Wittelsbacherplatz 2
W-8000 München 2(DE)**

(72) Erfinder: **Bardahl, Nils, Dr.
Albert-Schweitzer-Strasse 15
W-8525 Uttenreuth(DE)**

(54) **Gehäuse für Halbleiterbauelement.**

(57) Beschrieben wird eine Anordnung mit einem Halbleiterbauelement (D), insbesondere für die Leistungselektronik. In der Regel sind die Elemente (M,S) für die elektrische Funktion bei Halbleiterbauelementen für die Leistungselektronik im Innern eines Gehäuses (G) angebracht. Zwischen diesen Elementen (M,S) und den inneren Gehäusebegrenzungen besteht ein im allgemeinen kreisringförmiger Hohlraum. Bei Überschreiten eines vorgegebenen Grenzwertes kann in diesem Hohlraum ein Lichtbogen entstehen, der das Gehäuse (G) zerstören und sich unter hohem Druck explosionsartig auch in den das Gehäuse umgebenden Raum ausbreiten kann. Um die Ausbreitung des Lichtbogens in den umgebenden Raum zu verhindern, wird das Halbleiterbauelement (D) in demjenigen Bereich umkapselt, bei dem im Störungsfall mit Lichtbogenerscheinungen zu rechnen ist. Das zwischen der Umkapselung und dem Gehäuse (G) des Halbleiterbauelements (D) gebildete Volumen (V) soll dabei sehr viel größer als das innere Volumen (H) des Hohlraums sein.

FIG 2

## ANORDNUNG MIT EINEM HALBLEITERBAUELEMENT

Die Erfindung bezieht sich auf eine Anordnung mit einem Halbleiterbauelement, insbesondere für die Leistungselektronik. Die Elemente für die elektrische Funktion sind bei solchen Halbleiterbauelementen in der Regel konzentrisch im Innern eines Gehäuses angebracht, so daß zwischen diesen Elementen und den inneren Gehäusebegrenzungen ein im allgemeinen kreisringförmiger Hohlraum besteht. Durch das Gehäuse wird das eigentliche Halbleitersystem - eine mit verschieden dotierten Schichten versehene Halbleiterscheibe - gegen mechanische Beschädigung und atmosphärische Einflüsse geschützt.

Halbleiterbauelemente für die Leistungselektronik sind beispielsweise in Heumann, Klemens: Grundlagen der Leistungselektronik, 4. Auflage, Stuttgart: Teubner, 1989, beschrieben. Sie sind im Rahmen der vom Hersteller nach DIN 41782 anzugebenden Spannungs- und Strom-Grenzwerte zu betreiben. Bei Überschreiten eines dieser Grenzwerte, dem sogenannten Grenzlastintegral (das ist das Integral über das Quadrat des Stromes nach der Zeit und wird auch als $I^2t$-Ausblaswert oder Gehäusebruchstrom bezeichnet), kann es vorkommen, daß im Innern des Gehäuses ein Lichtbogen entsteht, der sich im Hohlraum ausbreitet, ein oder mehrere Löcher in das Gehäuse brennt und sich dann unter sehr hohem Druck explosionsartig auch in den das Gehäuse umgebenden Raum ausbreitet. Findet der Lichtbogen außerhalb des Gehäuses einen neuen Fußpunkt, so wird er weiterbrennen und kann erhebliche Schäden, beispielsweise an Gleichrichteranlagen oder an den Einrichtungen, an denen das Halbleiterbauelement befestigt ist, verursachen.

Aufgabe der Erfindung ist es den Lichtbogen außerhalb des Gehäuses eines Halbleiterbauelements aufzufangen.

Gemäß der Erfindung wird diese Aufgabe durch eine Anordnung mit einem Halbleiterbauelement gelöst, wobei sich im Gehäuse des Halbleiterbauelements Elemente für die elektrische Funktion des Halbleiterbauelements befinden, wobei zwischen den Elementen für die elektrische Funktion im Innern des Gehäuses und den inneren Gehäusebegrenzungen ein Raum mit einem inneren Volumen besteht, wobei das Gehäuse des Halbleiterbauelements in demjenigen Bereich umkapselt ist, bei dem im Störungsfall mit Lichtbogenerscheinungen zu rechnen ist und wobei zwischen der Umkapselung und dem Gehäuse des Halbleiterbauelements ein äußeres Volumen freigehalten ist.

Ein aus dem Gehäuse eines Halbleiterbauelements unter hohem Druck austretender Lichtbogen kann dann bei entsprechender Bemessung des äußeren Volumens aufgefangen werden.

Bei Halbleiterdioden und Thyristoren haben sich im mittleren und hohen Leistungsbereich zwei Standardbauformen herausgebildet: Die einseitig kühlbare Zelle mit Flachboden oder Schraubbolzen und die zweiseitig kühlbare Scheibenzelle.

Für die zweiseitig kühlbare Scheibenzelle ist eine vorteilhafte Ausbildung der Erfindung anwendbar die dadurch gekennzeichnet ist, daß das Gehäuse des Halbleiterbauelements zwei planparallele Deckflächen aufweist, die als Kontaktflächen für elektrische Anschlüsse ausgebildet sind, wobei das Halbleiterbauelement zwischen zwei Stromleitern angeordnet ist, wobei die beiden Kontaktflächen mit den Stromleitern kontaktieren, wobei das Halbleiterbauelement von einer isolierenden Dichtung umgeben ist, die ebenfalls zwischen den beiden Stromleitern angeordnet ist und wobei das äußere Volumen durch die Dichtung, die Stromleiter und das Halbleiterbauelement gebildet wird.

Die Umkapselung des Gehäuses des Halbleiterbauelements kann auch aus zwei Deckflächen bestehen, die im Bereich der Kontaktflächen der Halbleiterbauelemente ausgespart sind, um deren direkten Kontakt mit den Stromleitern zu ermöglichen. Bei dieser Ausbildung der Erfindung wird das äußere Volumen durch eine Dichtung, die Deckflächen und das Halbleiterbauelement gebildet. Sie läßt sich vorteilhaft dann anwenden, wenn die eigentlichen Stromleiter nicht den gesamten Bereich der oberen und unteren Flächen der Umkapselung abdecken. Eine weitere Ausbildung der Erfindung ist dadurch gekennzeichnet, daß das Verhältnis von äußerem Volumen zu innerem Volumen sehr viel größer als 1 ist. Erfahrungsgemäß wird der Zweck der Anordnung besonders gut bei einem Volumenverhältnis von ca. 100 : 1 erreicht.

Eine weitere vorteilhafte Ausbildung der Erfindung ist dadurch gekennzeich gekennzeichnet, daß mindestens einer der Stromleiter im Bereich der Dichtung so ausgebildet ist, daß die Dichtung fixiert wird. Dies kann vorteilhafterweise dadurch geschehen, daß bei mindestens einem Stromleiter eine Nut vorgesehen ist, durch die die Dichtung fixiert wird. Durch diese Maßnahme kann zum einen die Montage der Anordnung erleichtert werden zum andern wird eine größere mechanische Festigkeit der Dichtung erzielt.

Schließlich besteht eine vorteilhafte Ausbildung der Erfindung darin, daß in das äußere Volumen ein Material eingebracht wird, das einen Lichtbogen diffundieren läßt. Ein solches Material könnte ein Granulat, beispielsweise Sand sein. Ein aus dem inneren Volumen austretender Lichtbogen kann dann nur diffus im äußeren Volumen brennen und verliert dabei seine Zerstörungskraft. Das Verhältnis von äußerem zu innerem Volumen läßt sich dadurch verkleinern, so daß die Anordnung kompakter ausführbar ist.

Eine Ausbildung der Erfindung ist in der Zeichnung dargestellt und wird im folgenden näher erläutert. Dabei zeigen:

FIG 1 ein Halbleiterbauelement in der Ausführung als zweiseitig kühlbare Scheibenzelle,

FIG 2 eine Anordnung mit einer umkapselten zweiseitig kühlbaren Scheibenzelle,

FIG 3 eine Anordnung mit einer umkapselten zweiseitig kühlbaren Scheibenzelle und einer Verspannvorrichtung,

FIG 4 eine Anordnung nach FIG 3 mit gesonderten Deckflächen zur Bildung des äußeren Volumens.

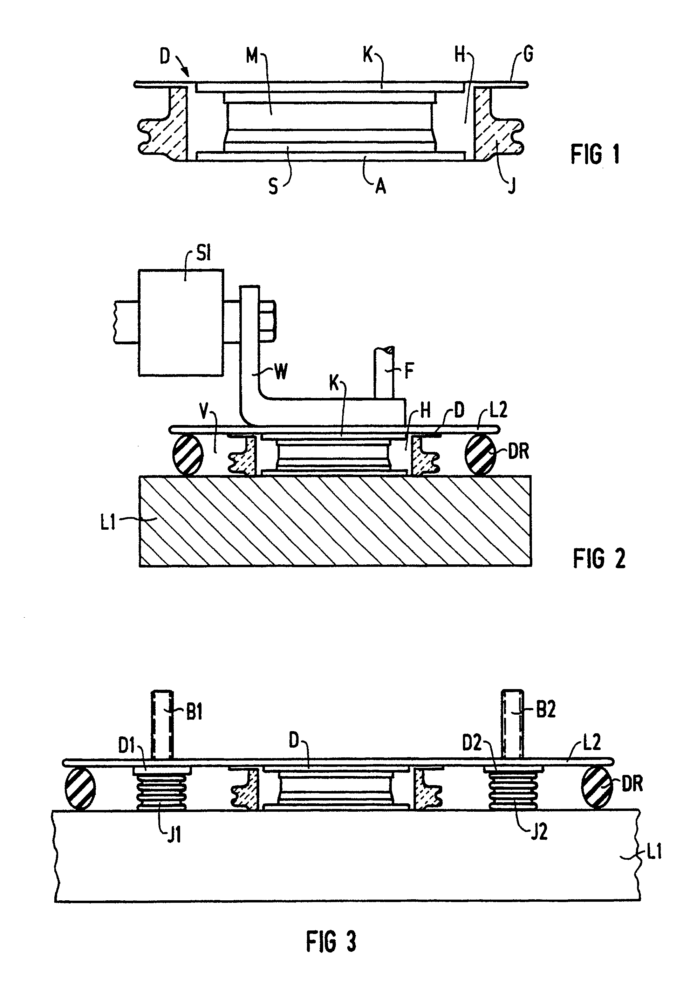

FIG 1 zeigt eine zweiseitig kühlbare Scheibenzelle im folgenden als Scheibendiode D bezeichnet, wie sie in der Leistungselektronik verwendet wird. Das Gehäuse G der Scheibendiode D wird gebildet durch einen Keramikring 3 als Isolator, der Anode A und der Kathode K. Im Innern des Gehäuses G befindet sich als eigentliches Halbleitersystem eine mit verschieden dotierten Schichten versehen Siliziumscheibe S. Auf der Siliziumscheibe S findet sich ein weiteres scheibenförmiges Element M das den mechanischen und elektrischen Kontakt zwischen der Siliziumscheibe S und der Kathode K herstellt.

Die Kathode K ist dabei am Keramikring J so befestigt, daß sie in Richtung der Symmetrieachse beweglich ist. Der für die elektrische Funktion notwendige Kontaktdruck wird durch Verspannen der Anode A und Kathode K gegeneinander erzeugt, wobei über die Anode A und die Kathode K, sowie über vorzusehende Kühlkörper gleichzeitig die entstehende Wärme abgeführt werden kann. Auf das Verspannen der Anode A gegen die Kathode K, sowie auf die Wärmeabfuhr wird im Zusammenhang mit den Figuren 2 und 3 noch näher eingegangen.

Durch die zentrisch angeordnete Siliziumscheibe S und das ebenfalls zentrisch angeordnete scheibenförmige Element M, sowie durch die Bauformen von Anode A und Kathode K und den Keramikring J wird ein Hohlraum mit einem inneren Volumen H im Innern des Gehäuses G gebildet. Im inneren Volumen H kann bei Überschreitung der vorgeschriebenen Grenzwerte ein Lichtbogen entstehen, der einen sehr hohen Druck erzeugt und der beispielsweise die Kathode K - in der Regel an der dünnsten Stelle -durchbrennen kann, um dann explosionsartig nach außen zu entweichen.

Um zu verhindern, daß der Lichtbogen in dem die Scheibendiode umgebenden Raum, einen neuen Fußpunkt findet und seine zerstörerische Wirkung weiter fortsetzt, wird die Scheibendiode, wie im folgenden anhand der FIG 2 beschrieben, umkapselt.

FIG 2 zeigt eine Anordnung mit einer verkapselten Scheibendiode D. Die Scheibendiode D und ein sie umgebender Dichtring DR aus elastischem, isolierenden Material sind auf einem, im Querschnitt gezeigten elektrischen Leiter L1 angeordnet. Ein zweiter elektrischer Leiter L2 ist parallel zum elektrischen Leiter L1 angeordnet, so daß durch die Scheibendiode D, den Dichtring DR, den elektrischen Leiter L1 und den elektrischen Leiter L2 ein Raum gebildet wird, der ein äußeres Volumen V aufweist.

Auf dem elektrischen Leiter L2 ist ein Winkelelement W angeordnet, das über Schlauchanschlüsse F flüssigkeitskühlbar ist. Auch der elektrische Leiter L1 ist über solche, der Übersichtlichkeit halber jedoch nicht gezeigte Schlauchanschlüsse mit einer Flüssigkeit kühlbar, so daß die Wärmeabfuhr von der Scheibendiode D über den kühlbaren elektrischen Leiter L1 sowie über den elektrischen Leiter L2 und das kühlbare Winkelelement W erfolgen kann. Am Winkelelement W ist eine Sicherung SI befestigt.

Das äußere Volumen V der Anordnung soll wesentlich größer als das innere Volumen H der Scheibendiode D sein. Brennt ein Lichtbogen durch das Gehäuse der Scheibendiode D, so kann sich der durch die Lichtbogenbildung aufgebaute sehr hohe Druck im Innern der Scheibendiode D in dem großen äußeren Volumen V abbauen, so daß eine wesentliche Bedingung für das Aufrechterhalten des Lichtbogens reduziert wird. Der Lichtbogen kann damit im äußeren Volumen V zumindest solange aufgefangen werden, bis die Sicherung SI anspricht.

FIG 3 zeigt eine Anordnung mit einer umkapselten Scheibendiode D und einer Verspannvorrichtung. Dabei ist die Scheibendiode D und der Dichtring DR wieder zwischen den elektrischen Leitern L1 und L2 angebracht. Am elektrischen Leiter L1 sind zusätzlich zwei Isolierstützen J1, J2 befestigt, an dessen oberen Ende sich jeweils ein Gewindebolzen B1, B2 befindet. Über diese Gewindebolzen B1, B2 kann zum einen das in FIG 2 gezeigte Winkelelement W befestigt werden, zum anderen dienen sie zum Verspannen der Scheibendiode D und des Dichtrings DR gegen den elektrischen Leiter L1.

Damit durch die Bohrungen die für die Gewindebolzen B1, B2 im elektrischen Leiter L2 vorgesehen sind, keine undichte Stelle im äußeren Volumen V auftritt, durch die ein Lichtbogen sich seinen seinen Weg ins Freie bahnen könnte, sind die Isolierstützen J1,J2 an ihrem oberen Ende mit elastischen Dichtungen D1, D2 abgedichtet.

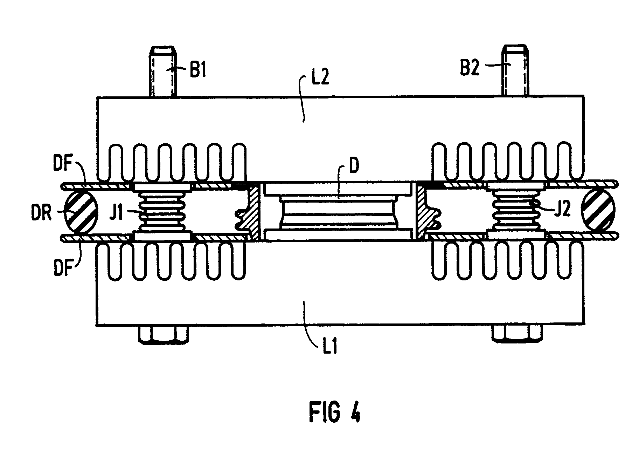

FIG 4 zeigt eine ähnliche Anordnung wie FIG 3. Der Unterschied zu FIG 3 besteht darin, daß die Stromleiter L1 und L2 nur im Bereich der elektrischen Anschlüsse der Diode D planparallel ausgebildet sind. Im übrigen, für die Umkapselung der Diode D vorgesehenen Bereich, sind die Stromleiter L1, L2 zur besseren Kühlung lamellenförmig ausgebildet, so daß sie keine Deckflächen für die Umkapselung bilden können.

Aus diesem Grund werden zusätzliche Deckflächen DF aus leitendem oder auch aus isolierendem Material verwendet, die im Bereich der elektrischen Anschlüsse der Diode D ausgespart sein können bzw. bei isolierendem Material selbstverständlich ausgespart sein müssen.

Auch hier können überall dort, wo ein Lichtbogen sich seinen Weg ins Freie bahnen könnte, elastische Dichtungen angebracht werden.

**Ansprüche**

1. Anordnung mit einem Halbleiterbauelement (D), die folgende Merkmale aufweist:

    a) Im Gehäuse (G) des Halbleiterbauelements (D) befinden sich Elemente (M,S) für die elektrische Funktion des Halbleiterbauelements (D),

    b) zwischen den Elementen (M,S) für die elektrische Funktion im Innern des Gehäuses (G) und den inneren Gehäusebegrenzungen besteht ein Raum mit einem inneren Volumen (H),

    c) das Gehäuse (G) des Halbleiterbauelements (D) ist in demjenigen Bereich umkapselt, bei dem im Störungsfall mit Lichtbogenerscheinungen zu rechnen ist,

    d) zwischen der Umkapselung und dem Gehäuse (G) des Halbleiterbauelements (D) ist ein äußeres Volumen (V) freigehalten.

2. Anordnung mit einen Halbleiterbauelement (D) nach Anspruch 1, **gekennzeichnet** durch folgende Merkmale:

    a) Das Gehäuse (G) des Halbleiterbauelements (D) weist zwei planparallele Deckflächen auf, die als Kontaktflächen für elektrische Anschlüsse (A,K) ausgebildet sind,

    b) das Halbleiterbauelement (D) ist zwischen zwei Stromleitern (Ll,L2) angeordnet, wobei die beiden Kontaktflächen mit den Stromleitern (L1,L2) kontaktieren,

    c) das Halbleiterbauelement (D) ist von einer isolierenden Dichtung (DR) umgeben, die ebenfalls zwischen den beiden Stromleitern (L1,L2) angeordnet ist,

    d) das äußere Volumen (V) wird durch die Dichtung (DR), die Stromleiter (L1,L2) und das Halbleiterbauelement (D) gebildet.

3. Anordnung mit einen Halbleiterbauelement (D) nach Anspruch 1, **gekennzeichnet** durch folgende Merkmale:

    a) Das Gehäuse (G) des Halbleiterbauelements (D) weist zwei planparallele Deckflächen auf, die als Kontaktflächen für elektrische Anschlüsse (A,K) ausgebildet sind,

    b) das Halbleiterbauelement (D) ist zwischen zwei Stromleitern (L1,L2) angeordnet, wobei die beiden Kontaktflächen mit den Stromleitern (L1,L2) kontaktieren,

    c) die Umkapselung des Gehäuses (G) des Halbleiterbauelements (D) besteht aus

        c1) zwei Deckflächen, die im Bereich der Kontaktflächen der Halbleiterbauelemente ausgespart sind,

        c2) einer isolierenden Dichtung (DR), die zwischen den Deckflächen und um das Halbleiterbauelement angeordnet ist,

    d) das äußere Volumen (V) wird durch die Dichtung (DR) die Deckflächen und das Halbleiterbauelement (D) gebildet.

4. Anordnung nach einem der vorstehenden Ansprüche 1, **dadurch gekennzeichnet,** daß das Verhältnis von äußerem Volumen (V) zu innerem Volumen (H) sehr viel größer als eins ist.

5. Anordnung nach Anspruch 4, **dadurch gekennzeichnet,** daß das Verhältnis von äußerem Volumen (V) zu innerem Volumen (H) ca. 100 : 1 ist.

6. Anordnung nach den Ansprüchen 2 bis 5,- **dadurch gekennzeichnet,** daß mindestens einer der Stromleiter (L1,L2) oder eine der Deckflächen im Bereich der Dichtung (DR) so ausgebildet ist, daß die Dichtung (DR) fixiert wird.

7. Anordnung nach Anspruch 6, **dadurch gekennzeichnet,** daß bei mindestens einem Stromleiter (L1,L2) oder einer Deckfläche eine Nut vorgesehen ist, durch die die Dichtung (DR) fixiert wird.

8. Anordnung nach einem der vorstehenden Ansprüche, **dadurch gekennzeichnet,** daß in das äußere Volumen (V) ein Material eingebracht wird, das einen Lichtbogen diffundieren läßt.

FIG 1

FIG 2

FIG 3

5

FIG 4